# EUROPÄISCHE PATENTSCHRIFT

(11) **EP 0 615 211 B1**
(45) Veröffentlichungstag und Bekanntmachung des Hinweises auf die Patenterteilung: **04.02.1998**
(21) Anmeldenummer: 93103951.5
(22) Anmeldetag: 11.03.1993
(51) Int. Cl.: G07B 17/02

(54) **Verfahren zum Speichern sicherheitsrelevanter Daten**
Device for storing security data
Dispositif pour mémoriser des données de sécurité

(43) Veröffentlichungstag der Anmeldung: 14.09.1994
(73) Patentinhaber: Francotyp-Postalia Aktiengesellschaft & Co., 16547 Birkenwerder (DE)
(72) Erfinder: Günther, Stephan, W-1000 Berlin 28 (DE); Kunde, Christoph, W-1000 Berlin 28 (DE)
(74) Vertreter: Schaumburg, Thoenes, Thurn Patentanwälte

(56) Entgegenhaltungen:
- EP-A- 0 226 205
- EP-A- 0 356 052
- EP-A- 0 376 486
- EP-A- 0 457 114

## Beschreibung

Die Erfindung betrifft ein Verfahren zum Speichern sicherheitsrelevanter Daten in einer Frankiermaschine, bei dem gleiche Daten in mehreren Speicherbereichen abgespeichert werden, die Daten aus den Speicherbereichen wieder ausgelesen und Daten des einen Speicherbereichs mit Daten eines anderen Speicherbereichs verglichen werden, und bei dem Speicherbereiche mit fehlerhaften Daten festgestellt werden.

Ein derartiges Verfahren erhöht die Datensicherheit in einer Frankiermaschine, da das Auftreten fehlerhafter Daten festgestellt und angezeigt werden kann. Solche Verfahren haben besondere Bedeutung beim Speichern sicherheitsrelevanter Daten, zu denen in Frankiermaschinen Portowerte gehören, die vor Manipulation durch Unberechtigte geschützt werden müssen. Im Speicher einer Frankiermaschine werden z.B. der Portorestbetrag gespeichert, der den noch nicht aufgebrauchten Portobetrag angibt und der bei jedem Frankiervorgang reduziert wird. Ferner wird der verbrauchte Portowert gespeichert, d.h. die Summe der beim Frankieren gedruckten Portowerte. Außerdem wird ein Kontrollwert gespeichert, der die während der Lebensdauer der Frankiermaschine verbrauchten Portowerte angibt.

Bei dem bekannten Verfahren werden gleiche sicherheitsrelevante Daten mehrfach abgespeichert. Zur Überprüfung der Daten auf Fehler werden diese Daten geladen und mit entsprechenden Daten aus den anderen Speicherbereichen verglichen. Anhand des Vergleichs kann zwar festgestellt werden, ob ein Datenfehler vorliegt, jedoch kann der Datenfehler selbst nicht behoben, d.h. die Daten nicht berichtigt werden. Die Frankiermaschine muß daher beim Auftreten eines Datenfehlers außer Betrieb gesetzt werden, was erhebliche wirtschaftliche Nachteile zur Folge haben kann. Ein solcher Betriebsvorfall führt zu erheblichen Kosten.

Ferner ist ein Verfahren zum Speichern von Daten bekannt, bei dem defekte Speicherelemente, welche die Ursache für Datenfehler sein können, markiert werden. Beim Abspeichern von neuen Daten werden die markierten Speicherelemente umgangen. Dieses Verfahren setzt voraus, daß die defekten Speicherelemente sicher erkannt werden können und daß die Datenfehler nicht sporadisch auftreten, wie es beispielsweise bei Datenfehlern der Fall sein kann, die durch spontanen radioaktiven Zerfall in einem elektrischen Speicher hervorgerufen werden.

In der EP 0 188 382 Bl ist ein Verfahren zum Speichern sicherheitsrelevanter Daten in einer Frankiermaschine beschrieben, bei dem ein Summenwert verbrauchter Postwerte mit einem vorbestimmten Testwert verglichen wird. Wenn beide Werte unterschiedlich sind, wird ein Fehlersignal ausgegeben, das auf einen Datenfehler hinweist.

Aus der EP 0 226 205 B1 ist ferner ein Speicherverfahren bekannt, bei dem Daten eines ersten Speicherbereichs in gleicher Weise in einen zweiten Speicherbereich abgelegt werden. Wenn ein schwerwiegender Fehler oder ein Hardwarefehler im ersten Speicherbereich auftritt, so werden die Daten des zweiten Speicherbereichs in einen vorab reservierten weiteren Speicherbereich eingeschrieben, der die Funktion des ersten Speicherbereichs übernimmt.

Es ist Aufgabe der Erfindung, ein Verfahren zum Speichern sicherheitsrelevanter Daten in einer Frankiermaschine anzugeben, bei dem mit geringem Aufwand fehlerhafte Daten sicher festgestellt und bei Vorliegen bestimmter Fehlerarten die fehlerhaften Daten berichtigt werden.

Diese Aufgabe wird für ein Verfahren eingangs genannter Art dadurch gelöst, daß gleiche Daten in mindestens vier Speicherbereichen abgespeichert werden, daß die Daten eines jeden Speicherbereichs mit den Daten weiterer Speicherbereiche verglichen werden, und daß abhängig von diesem Vergleich der oder die Speicherbereiche mit fehlerhaften Daten festgestellt und gegebenenfalls mit Daten aus einem Speicherbereich mit nicht fehlerhaften Daten wieder geladen werden.

Gemäß der Erfindung werden gleiche Daten in mindestens vier Speicherbereichen abgespeichert. Diese Speicherbereiche können Teile eines einzigen Speichers sein oder in verschiedenen, voneinander elektronisch abgetrennten Speichern enthalten sein. Vorzugsweise sind die Speicherbereiche jeweils in separaten elektronischen Speichern enthalten, die möglichst unabhängig voneinander mit Strom versorgt werden und/oder verschiedene Speicherprinzipien anwenden. Dadurch wird die Wahrscheinlichkeit, daß mehrere Speicher gleichzeitig ausfallen, und damit ein Datenverlust eintritt, verringert.

Bei der Erfindung wird nicht das fehlerhafte Datum oder Daten in einem oder mehreren Speicherbereichen selbst festgestellt, sondern derjenige Speicherbereich, in dem das fehlerhafte Datum oder fehlerhafte Daten enthalten sind. Hierzu werden die Daten eines jeden Speicherbereichs mit den Daten weiterer Speicherbereiche verglichen. Wenn zum Beispiel die Daten in vier Speicherbereichen abgespeichert werden, so kann jeder dieser vier Speicherbereiche mit den verbleibenden drei anderen Speicherbereichen verglichen werden. Dies bedeutet, daß bei diesem Beispiel sechs Vergleiche der Speicherinhalte untereinander ausgeführt werden. Die Vergleiche können byteweise bitorientiert unter Awendung einer Exklusiv-Oder-Verknüpfung durchgeführt werden. Da kein Unterschied gemacht wird, ob nur ein Bit einer Speicherstelle eines bestimmten Speicherbereiches oder sämtliche binären Daten eines Speicherbereichs fehlerhaft sind, können die Vergleiche sehr schnell mit Hilfe bekannter Vergleichsalgorhithmen ausgeführt werden. Die hohe Geschwindigkeit beim Vergleichen ist darauf zurückzuführen, daß die fehlerhaften Daten selbst nicht identifiziert werden müssen.

Durch die Erfindung wird erreicht, daß bei einem bestimmten Datenfehlertyp der Speicherbereich mit fehlerhaften Daten festgestellt und mit nicht fehlerhaften Daten neu geladen werden kann. Dies soll anhand eines Beispiels kurz erläutert werden: Es sei angenommen, daß von vier Speicherbereichen zwei fehlerfreie Daten und zwei weitere Speicherbereiche fehlerhafte Daten enthalten. Bei den sechs Vergleichen der Daten der Speicherbereiche untereinander wird nun bei fünf Vergleichen fehlende Übereinstimmung der Daten festgestellt und lediglich bei den beiden Speicherbereichen mit fehlerfreien Daten stimmen diese überein. Bei diesem einfachen Fall können die fehlerfreien Speicherbereiche auf einfache Weise ermittelt werden. Die fehlerhaften Daten in den anderen Speicherbereichen werden dann mit fehlerfreien Daten der ordnungsgemäßen Speicherbereiche überschrieben. Auf diese Weise sind nach Durchführen des Verfahrens sämtliche vier Speicherbereiche mit fehlerfreien Daten gefüllt, ohne daß die fehlerhaften Daten genau identifiziert werden mußten.

Bei einem bevorzugten Ausführungsbeispiel der Erfindung werden in mindestens zwei Speicherbereichen die Daten invertiert abgespeichert, wobei zum Vergleich mit nicht invertierten Daten die invertierten Daten negiert werden. Ein häufig vorkommender Datenfehler ist darin begründet, daß die Stromversorgung der oder des physikalischen Speichers, welcher einen oder mehrere Speicherbereiche enthält, ausfällt und sämtliche Daten dieses Speicherbereichs oder dieser Speicherbereiche den Wert 0 oder 1 haben. In einem solchen Fall wird bei den verschiedenen Vergleichen jeweils Übereinstimmung der Daten dieser Speicherbereiche festgestellt, obwohl ein gravierender Datenfehler vorliegt. Durch die Maßnahme der Weiterbildung wird ein solcher Zustand verhindert.

Bei einer anderen Ausgestaltung der Erfindung erfolgt der Vergleich der Daten durch eine Exklusiv-Oder-Verknüpfung, wobei der Vergleich vorzugsweise byteweise bitorientiert durchgeführt wird. Bei dieser Art der Verknüpfung ist bei Übereinstimmung der Daten das binäre Ergebnis bei positiver Logik "0" bzw. "1" bei negativer Logik. Diese Verknüpfung läßt sich sehr schnell durchführen, so daß für die Vergleiche wenig Zeit beansprucht wird. Außerdem hat die Exklusiv-Oder-Verknüpfung den Vorteil, daß das Ergebnis unabhängig davon ist, ob nicht invertierte Daten oder invertierte Daten miteinander verglichen werden.

Eine bevorzugte Weiterbildung der Erfindung ist dadurch gekennzeichnet, daß eine Fehlerzahl ermittelt wird, die die Zahl der Vergleiche angibt, bei denen fehlende Übereinstimmung der Daten der Speicherbereiche festgestellt worden ist, und daß die Datenfehler abhängig von der Fehlerzahl behoben werden. Durch diese Maßnahme wird erreicht, daß die Art des Fehlers anhand der Fehlerzahl festgelegt werden kann. Da es für verschiedene Fehlerarten unterschiedliche Routinen zur Fehlerbehebung gibt, kann im Rahmen einer Softwareroutine anhand der Fehlerzahl zu Programmteilen verzweigt werden, die eine Fehleranalyse, eine Fehlerbehebung oder eine Fehleranzeige bewirken. Dadurch wird eine einfache und dennoch effiziente Fehleranalyse durchgeführt und Maßnahmen zur Fehlerbehebung eingeleitet.

Gemäß einer Weiterbildung der Erfindung wird vor oder beim Abspeichern der Daten in den Speicherbereichen aus den Daten eines jeden Speicherbereichs eine erste Prüfsumme gebildet und abgespeichert. Beim Auslesen der Daten oder danach wird über die Daten der Speicherbereiche jeweils eine zweite Prüfsumme ermittelt, die mit der ersten Prüfsumme verglichen wird. Wird ein Fehler festgestellt, so wird dieser abhängig vom Vergleich der Prüfsumme behoben. Die Prüfsumme kann nach Art des bekannten Parity-Verfahrens ermittelt werden. Hierbei werden die Daten in einer Matrix angeordnet und aus den Zeilendaten und/oder Spaltendaten Prüfbits ermittelt, die zu einem Datenwort zusammengesetzt als Prüfsumme verwendet werden. Da die Prüfsummen beim ersten Abspeichern der Daten und beim späteren Auslesen der Daten auf die gleiche Weise gebildet werden, macht sich ein Datenfehler auch in der Prüfsumme bemerkbar. Durch den Prüfsummenvergleich kann der Speicherbereich mit fehlerhaften Daten eingegrenzt werden und so Maßnahmen zum Beheben des Fehlers ergriffen werden.

Ein Beispiel, bei dem gleiche Daten in vier Speicherbereichen abgespeichert werden, soll dies verdeutlichen. Es wird angenommen, daß bei den sechs Vergleichen der Daten eines jeden Speicherbereichs mit den Daten der anderen Datenbereiche drei Vergleiche mit fehlender Übereinstimmung der Daten festgestellt worden sind. Dies kann bedeuten, daß einer der vier Speicherbereiche ein defektes Datum enthält und die anderen drei Speicherbereiche keine fehlerhaften Daten enthalten. Drei Vergleiche, in denen Datenfehler festgestellt werden, liegen aber auch vor, wenn die Daten nur eines einzigen Speicherbereichs fehlerfrei sind, wobei die anderen drei Speicherbereiche jeweils gleiche Fehler haben, beispielsweise wegen Spannungsausfall nur Daten "0" oder "1" enthalten. Es liegen also verschiedene Fehlerarten bei gleicher Fehlerzahl vor. Diese Fehlerzahl liefert dann kein Kriterium zur Unterscheidung dieser Fehlerarten und zur Einleitung weiterer Maßnahmen zur Fehlerbehebung. Anhand eines Prüfsummenvergleichs kann bei diesem Beispiel herausgefunden werden, ob nur ein Speicherbereich defekte Daten enthält, oder ob drei Speicherbereiche fehlerhafte Daten enthalten.

Ein anderes Ausführungsbeispiel der Erfindung ist dadurch gekennzeichnet, daß bei einer Fehlerzahl 6 für jeden Speicherbereich ein Prüfsummenvergleich durchgeführt wird, und daß bei negativem Ergebnis aller Prüfsummenvergleiche ein Fehlersignal erzeugt wird, das angibt, daß der Fehler nicht behoben werden kann. Dieser Fall liegt vor, wenn in allen vier Speicherbereichen jeweils die Daten fehlerhaft sind, wobei sich die Fehler voneinander unterscheiden. In diesem Fall ist kein Speicherbereich vorhanden, dessen Daten zur Restaurierung anderer Speicherbereiche verwendet werden könnte. Daher wird bei diesem Ausführungsbeispiel angezeigt, daß ein Datenverlust aufgetreten ist, der mit den hier beschriebenen Maßnahmen nicht behoben werden kann.

Ferner kann vorgesehen sein, daß die über einen vorgegebenen Zeitraum je Speicherbereich auftretenden Fehler ermittelt und angezeigt werden. Dadurch wird es möglich, aufgrund der Häufigkeit der Datenfehler auf einen Defekt in der Hardware und/oder Software zu schließen, die für das Speichern verwendet werden. Die entsprechenden Speicherbereiche bzw. physikalischen Speichereinheiten können anhand einer Fehleranalyse identifiziert und gegebenenfalls ausgetauscht werden.

Bei einem weiteren Ausführungsbeispiel ist vorgesehen, daß die oben beschriebenen Verfahren selbstätig in vorgegebenen Zeitabständen durchgeführt werden. Dadurch wird erreicht, das auch Ereignisse, die Datenfehler hervorrufen und die nicht im Zusammenhang mit Speichervorgängen stehen, beispielsweise durch spontanen radioaktiven Zerfall hervorgerufene Datenfehler, zuverlässig erkannt und gegebenenfalls behoben werden. Außerdem ist es auch möglich, die oben beschriebenen Verfahren abhängig von einem äußeren Ereignis durchzuführen. Ein solches Ereignis kann zum Beispiel das Aufrufen einer Testroutine durch eine Bedienperson sein. Dadurch wird das Überprüfen der Frankiermaschine auf Datensicherheit unterstützt und die Diagnose von Fehlern erleichtert.

Ausführungsbeispiele der Erfindung werden im folgenden anhand der Zeichnungen erläutert. Darin zeigt:
- Figur 1: eine schematische Darstellung der Anordnung von vier Speicherbereichen in zwei voneinander unabhängigen elektronischen Speichern,
- Tabelle 1 bis 6: verschiedene Fehlertypen und die für diese charakteristische Vergleichsergebnisse,
- Figur 2a bis 2e: ein Flußdiagramm, das die Vefahrensschritte zum Speichern sicherheitsrelevanter Daten und die Behebung von Datenfehlern wiedergibt, und
- Figur 3: ein Flußdiagramm eines einfachen Ausführungsbeispiels, bei dem keine Fehlerzahl ermittelt und kein Prüfsummenvergleich durchgeführt wird,
- Figur 4: eine schematisch Darstellung einer Anordnung nach Fig. 1, wobei nur vier Datenvergleiche durchgeführt werden.
- Figur 5a und 5b: ein Flußdiagramm eines Ausführungsbeispiels mit einer Anordnung nach Figur 4, bei dem die Fehlertypen 1 und 3 bis 6 behandelt werden.

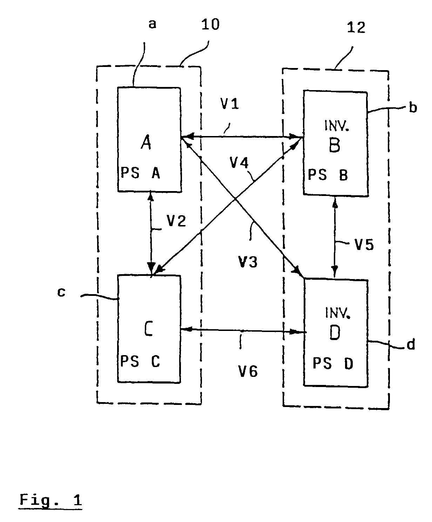

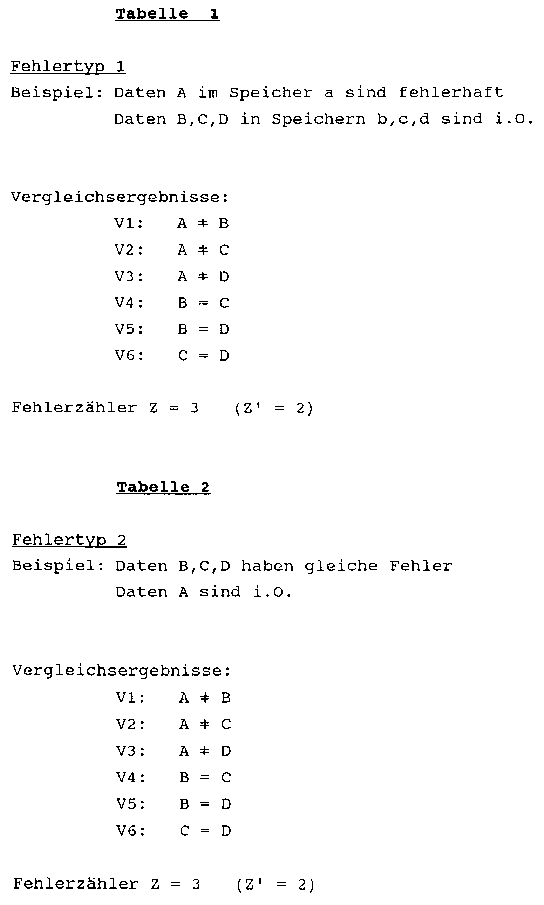

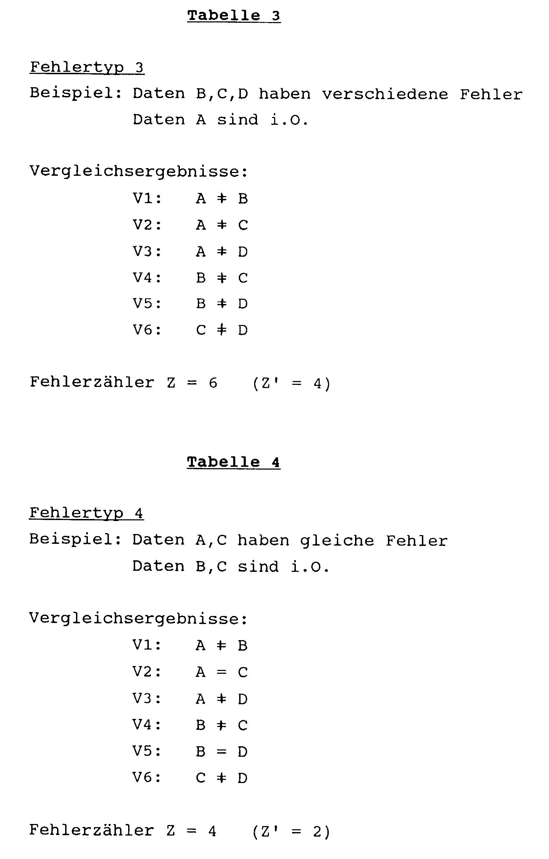

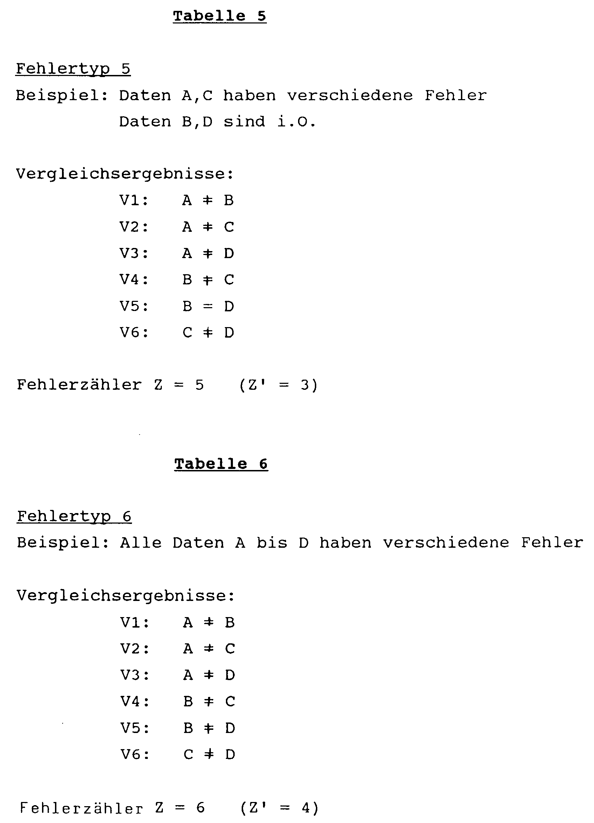

In Figur 1 hat ein erster elektronischer Speicher 10 zwei Speicherbereiche a und c, in denen in einer Frankiermaschine zu speichernde sicherheitsrelevante gleiche Daten A bzw. C abgespeichert werden. Ein zweiter elektronischer Speicher 12, der vom Speicher 10 physikalisch getrennt ist und eine separate Stromversorgung hat, enthält zwei Speicherbereiche b und d, in denen ebenfalls gleiche sicherheitsrelevante Daten B und D in invertierter Form gespeichert werden. Aus den Daten A bis D wird jeweils eine erste Prüfsumme PSA, PSB, PSC und PSD gebildet und im zugehörigen Speicherbereich a bis d gespeichert. Wie noch erläutert wird, werden diese Prüfsummen PSA bis PSD zur Identifizierung fehlerhafter Speicherbereiche a bis d verwendet.

Beim hier beschriebenen Ausführungsbeispiel werden die Daten eines jeden Speicherbereichs mit den Daten eines jeden anderen Speicherbereichs verglichen. Dies bedeutet, daß sechs Vergleiche V1 bis V6 durchgeführt werden, wie durch Pfeile in der Figur 1 angedeutet ist. Bei diesen Vergleichen wird in einem schnellen Prüfverfahren durch Direktvergleich der Daten A bis D untereinander festgestellt, ob die Daten (z.B. Daten A) eines oder mehrerer Speicherbereiche a bis d von den anderen Daten (z.B. Daten B bis D) abweichen oder nicht. Bei einer Abweichung wird nicht festgestellt, ob mehrere Daten oder ein bestimmtes Datum fehlerhaft ist. Der hierfür erforderliche Zeit- und Rechenaufwand wäre zu groß. Da auf eine solche Einzelanalyse verzichtet wird, ist es möglich, die Vergleiche in kurzer Zeit mit einfachen Softwareroutinen durchzuführen. Beispielsweise können die Vergleiche der Daten A bis D untereinander durch Exklusiv-Oder-Verknüpfungen erfolgen.

Zum Vergleichen gleichartiger Daten untereinander, d.h. invertierter bzw. nicht invertierter Daten, müssen diese nicht umgewandelt werden. Sind jedoch ungleichartige Daten untereinander zu vergleichen, so wird ein Satz der Daten vor Ausführen der Exclusiv-Oder-Verknüpfung negiert. Eine andere Möglichkeit besteht darin, den Vergleich ohne Änderung der Daten durchzuführen und dafür das Ergebnis der Exclusiv-Oder-Verknüpfung zu invertieren.

In den Tabellen 1 bis 6 sind Beispiele für verschiedene Fehlertypen 1 bis 6 angegeben, die nach dem Verfahren der Erfindung erkannt werden. In Tabelle 1 wird der Fehlertyp 1 behandelt. Bei diesem Fehlertyp hat ein Speicherbereich einen Datenfehler, d.h. ein Datum oder mehrere Daten unter den gesamten Daten im betreffenden Speicherbereich ist fehlerhaft. Die Daten in den anderen Speicherbereichen sind jeweils einwandfrei. In Tabelle 1 ist beispielhaft angenommen, daß die Daten A im Speicherbereich a fehlerhaft sind, während die Daten B, C, D in den Speicherbereichen b, c, d keinen Datenfehler haben. Gemäß dem Ausführungsbeispiel der Erfindung werden sechs Vergleiche V1 bis V6 der Daten A bis D untereinander durchgeführt, wobei es sich zeigt, daß drei Vergleiche V1,V2, V3 fehlende Übereinstimmung der Daten zeigen. Beim hier gewählten Beispiel sind an solchen Vergleichen mit fehlender Übereinstimmung jeweils die Daten A beteiligt. Es wird eine Fehlerzahl Z ermittelt, die angibt, wie oft fehlende Übereinstimmung der Daten A bis D der Speicherbereiche a bis d bei den Vergleichen V1 bis V6 festgestellt worden ist. Im vorliegenden Fall hat der Fehlerzähler Z den Wert 3. Ferner wird eine Fehlerzahl Z' angegeben, die sich auf die Vergleiche V1, V2, V5 und V6 bezieht und die bei einem später noch zu beschreibenden Ausführungsbeispiel ausgewertet wird.

In Tabelle 2 ist ein Beispiel für den Fehlertyp 2 dargestellt. Bei diesem Fehlertyp sind die Daten, zum Beispiel Daten A, fehlerfrei, während die Daten, zum Beispiel Daten B, C, D, fehlerhaft sind, wobei jeweils der selbe Fehler vorliegt. Beispielsweise kann es sein, daß die Daten B, C, D wegen eines Hardwarefehlers sämtliche den Wert "0" haben. Die Vergleichsergebnisse V1 bis V6 beim Vergleich der Daten A bis D untereinander zeigen fehlende Übereinstimmung bei drei Vergleichen V1, V2, V3. Dementsprechend hat der Fehlerzähler Z den Wert 3, wie auch beim vorhergehenden Beispiel mit Fehlertyp 1.

In Tabelle 3 ist ein Beispiel für den Fehlertyp 3 dargestellt. Bei diesem Fehlertyp sind die Daten eines einzigen Speicherbereichs einwandfrei, zum Beispiel die Daten A, während die Daten der anderen Speicherbereiche, zum Beispiel die Daten B, C, D fehlerhaft sind, wobei unterschiedliche Datenfehler vorliegen. Anhand der in der Tabelle 3 gezeigten Vergleichsergebnisse der Vergleiche V1 bis V6 ist zu erkennen, daß der Fehlerzähler Z den Wert 6 hat.

Für den Fehlertyp 4 wird in Tabelle 4 ein Beispiel angegeben. Dieser Fehlertyp 4 betrifft zwei Speicherbereiche, deren Daten jeweils den selben Fehler haben. In Tabelle 4 wird als Beispiel angenommen, daß die Daten A, C in den Speicherbereichen a, c gleiche Fehler haben. Die Daten B und D in den Speicherbereichen b, d sind fehlerfrei. Die in der Tabelle 4 angegebenen sechs Vergleiche V1 bis V6 führen zu dem Ergebnis, daß vier Vergleiche, nämlich V1, V3, V4 und V6, fehlende Übereinstimmung der Daten zeigen. Der Fehlerzähler Z hat demnach den Wert 4.

In Tabelle 5 wird der Fehlertyp 5 behandelt, bei dem die Daten in zwei Speicherbereichen fehlerhaft sind und verschiedene Fehler haben. Die Daten in den anderen Speicherbereichen sind fehlerfrei. In Tabelle 5 wird als Beispiel angenommen, daß die Daten A, C fehlerhaft und die Daten B, D fehlerfrei sind. Die Vergleiche V1 bis V6 der Daten A bis D untereinander führen zum Ergebnis, daß bei fünf Vergleichen V1 bis V4 und V6 fehlende Übereinstimmung der Daten der Speicherbereiche a bis d vorliegt. Der Fehlerzähler Z hat demnach den Wert 5.

Schließlich wird noch in Tabelle 6 der Fehlertyp 6 behandelt, bei dem die Daten A bis D in den vier Speicherbereichen a bis d verschiedene Fehler haben. Kein Vergleich V1 bis V6 zeigt hier eine Übereinstimmung der Daten. Der Fehlerzähler Z hat den Wert 6.

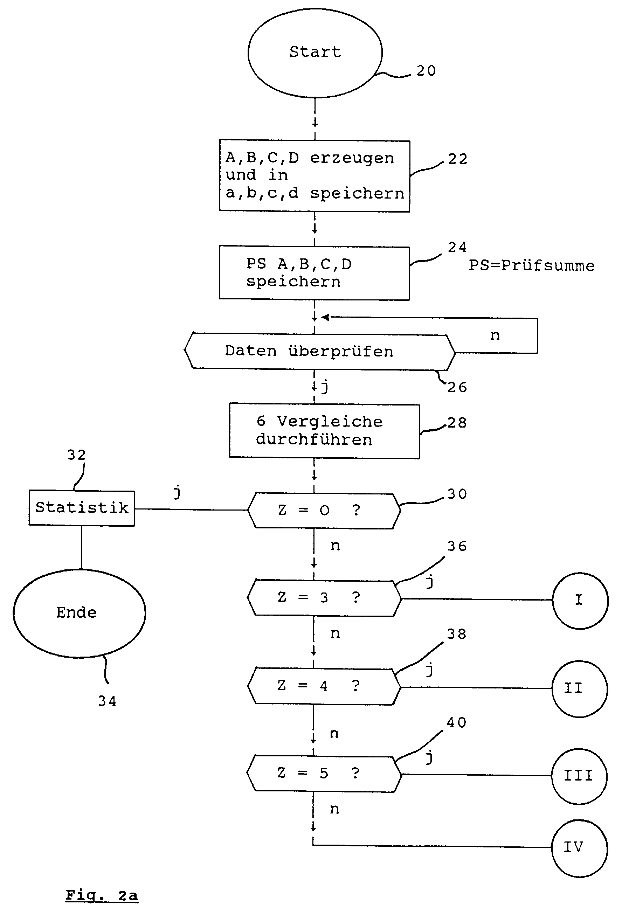

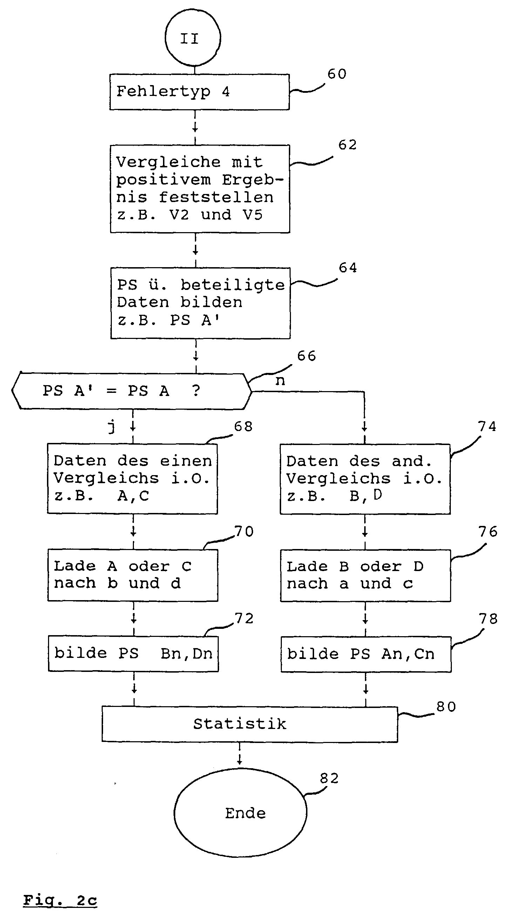

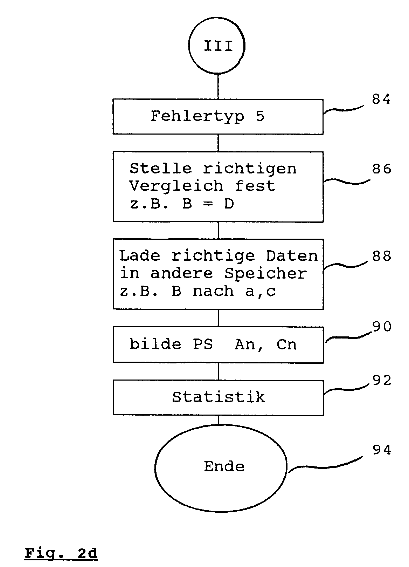

In den Figuren 2a bis 2e sind Verfahrensschritte des Ausführungsbeispiels mit vier Speicherbereichen a, b, c, d und den zugehörigen Daten A, B, C, D in einem Flußdiagramm dargestellt. Bei diesem Ausführungsbeispiel werden die in den Tabellen 1 bis 6 behandelten Fehlertypen 1 bis 6 erkannt und geeignete Maßnahmen zur Behebung des Fehlers oder zur Fehleranzeige ergriffen. Gemäß Figur 2a werden nach dem Start im Verfahrensschritt 20 die sicherheitsrelevanten gleichen Daten A, B, C, D erzeugt und in den Speicherbereichen a, b, c, d gespeichert (Schritt 22). Im Schritt 24 ist angegeben, daß aus den Daten A bis D eine erste Prüfsumme PSA bis PSD gebildet und gespeichert wird, vorzugsweise in den zugehörigen Speicherbereichen a bis d. Das Erzeugen der Prüfsummen PSA bis PSD kann vor oder beim Abspeichern der Daten A bis D erfolgen.

Im Verfahrensschritt 26 wird geprüft, ob eine Datenüberprüfung durchgeführt werden soll. Eine solche Prüfung kann selbsttätig in vorgegebenen Zeitabständen oder abhängig von einem äußeren Ereignis durchgeführt werden, beispielsweise im Rahmen eines Funktionstests. Falls eine Datenüberprüfung erfolgen soll, so werden im Verfahrensschritt 28 die Daten A bis D geladen und die Daten eines jeden Speicherbereichs a bis d mit den Daten der anderen Speicherbereiche a bis d verglichen. Bei vier Speicherbereichen sind also die in den Tabellen 1 bis 6 gezeigten sechs Vergleiche V1 bis V6 durchzuführen. Bei diesen Vergleichen V1 bis V6 wird eine Fehlerzahl Z ermittelt, die angibt, wie oft fehlende Übereinstimmung der Daten A bis D der Speicherbereiche a bis d vorliegt. Wird im Schritt 30 festgestellt, daß kein Fehler vorliegt, d.h. Z = 0 ist, so wird im nachfolgenden Schritt 32 dieses Ergebnis zu statistischen Zwecken ausgewertet und das Programm, in welchem die einzelnen Verfahrensschritte gespeichert sind, im Schritt 34 verlassen.

Falls in Schritt 36 festgestellt wird, daß der Fehlerzähler Z = 3 ist, so wird zum Programmabschnitt I verzweigt. Hat der Fehlerzähler den Wert Z = 4, so wird im Schritt 38 zum Programmabschnitt II verzweigt. Bei einem Fehlerzähler Z = 5 wird im Schritt 40 zum Programmabschnitt III gesprungen, andernfalls zum Programmabschnitt IV.

In der folgenden Beschreibung der Programmabschnitte I bis IV werden Beispiele für Datenfehler behandelt, die mit denen in den Tabellen 1 bis 6 übereinstimmen. Bei dem in Figur 26 gezeigten Programmabschnitt I wird im Schritt 42 festgestellt, daß die Daten A jeweils an Vergleichen beteiligt waren, die fehlerhafte Übereinstimmung der Daten zeigten. Im darauf folgenden Verfahrensschritt 44 wird aus den aktuellen Daten A eine zweite Prüfsumme PSA' gebildet. Im Verfahrensschritt 46 wird nun überprüft, ob die zweite Prüfsumme PSA' mit der ersten Prüfsumme PSA übereinstimmt. Falls dies zutrifft, so liegt der Fehlertyp 1 vor, was im Verfahrensschritt 48 festgestellt wird. Bei dem gewählten Beispiel (vgl. Tabelle 1) sind die Daten B, C und D fehlerfrei. Um die Daten im Speicherbereich a zu berichtigen, werden daher im Verfahrensschritt 50 die Daten B, C oder D in den Speicherbereich a geladen, der danach berichtigte neue Daten An enthält. Aus diesen Daten An wird im Verfahrensschritt 52 die Prüfsumme PSAn gebildet, die bei zukünftigen Datenüberprüfungen als erste Prüfsumme PSA verwendet wird.

Danach wird zum Verfahrensschritt 54 weitergegangen, in welchem der Datenfehler ausgewertet wird. Hierzu wird der Fehlertyp und der Speicherbereich festgehalten, in welchem der Datenfehler aufgetreten ist. Diese Daten werden statistisch ausgewertet und geben Auskunft über die Datensicherheit der Frankiermaschine bzw. die Ausfallhäufigkeit eines Speicherbereichs oder eines elektronischen Speichers. Danach wir im Schritt 56 das Programm verlassen.

Falls im Schritt 46 Übereinstimmung der Prüfsummen PSA' und PSA festgestellt wird, so wird zum Schritt 58 verzweigt. Hier wird festgestellt, daß der Fehlertyp 2 vorliegt, wie er z.B. in Tabelle 2 definiert ist. Im nachfolgenden Schritt 60 werden die fehlerfreien Daten A in die Speicherbereiche b, c, d als neue Daten Bn, Cn und Dn gespeichert. Aus diesen Daten Bn, Cn, Dn werden jeweils Prüfsummen PSBn, PSCn und PSDn gebildet, die bei einer Wiederholung der Datenüberprüfung als erste Prüfsummen PSB, PSC, PSD verwendet werden. Anschließend wird über Verfahrensschritt 54 zum Verfahrensschritt 56 weitergegangen und das Programm beendet.

In Figur 2c sind die Verfahrensschritte des Programmabschnitts II dargestellt. Dieser Programmabschnitt wird abgearbeitet, wenn der Fehlerzähler Z = 4 ist, d.h. es liegt der Fehlertyp 4 vor (Schritt 60). Im Schritt 62 wird festgestellt, welche Vergleiche V1 bis V6 positives Ergebnis haben. Beim gewählten Beispiel (vergleiche Tabelle 4) haben der zweite und fünfte Vergleich V2, V5 positives Ergebnis, d.h. die Daten A und C sowie B und D stimmen überein. Es wird nun im Schritt 64 aus den Vergleichen V2, V5 mit positivem Ergebnis ein Speicherbereich ausgewählt, zum Beispiel der Speicherbereich a, und aus den zugehörigen aktuellen Daten, die zweite Prüfsumme PSA' gebildet. Im nachfolgenden Schritt 66 wird überprüft, ob die zweite Prüfsumme PSA' mit der ersten Prüfsumme PSA übereinstimmt. Falls dies der Fall ist, wird im Schritt 68 festgelegt, daß die Daten, die am zweiten Vergleich V2 teilgenommen haben, fehlerfrei sind. Im vorliegenden Beispiel sind dies die Daten A und C. Im Schritt 70 werden nun diese Daten A oder C in die Speicherbereiche b und d mit den fehlerhaften Daten B und D geladen, so daß in diesen Speicherbereichen nunmehr fehlerfreie neue Daten Bn, Dn enthalten sind. Beim Speichern der Daten A oder C in die Speicherbereiche b und d oder davor werden aus den neuen Daten Bn und Dn jeweils die Prüfsumme PSBn, PSDn gebildet und in den zugehörigen Speicherbereichen b und d mit abgespeichert. Diese Prüfsummen PSBn, PSDn werden bei zukünftigen Datenüberprüfungen als erste Prüfsummen PSB, PSD verwendet. Im darauffolgenden Schritt 80 wird der festgestellte Fehler statistisch ausgewertet und anschließend im Schritt 82 das Programm beendet.

Falls die im Prüfschritt 66 miteinander verglichenen Prüfsummen PSA' und PSA nicht übereinstimmen, so wird im nachfolgenden Schritt 74 festgelegt, daß die Daten des anderen Vergleichs (Vergleich V5) mit positivem Ergebnis fehlerfrei sind, d.h. die Daten B und D. Diese Daten B oder D werden im Schritt 76 in die Speicherbereiche a und c geladen und im Verfahrensschritt 78 aus den neuen Daten An, Cn jeweils die Prüfsummen PSAn und PSCn gebildet. Anschließend wird über die Schritte 80 und 82 das Programm verlassen.

Zu dem in Fig. 2d dargestellten Programmabschnitt III wird verzweigt, wenn der Fehlerzähler Z = 5 ist. Demgemäß liegt der Fehlertyp 5 vor (vergleiche Tabelle 5), was im Schritt 84 festgestellt wird. Im nachfolgenden Schritt 86 wird ermittelt, welcher Vergleich Übereinstimmung der Daten erbrachte. Beim gewählten Beispiel ist es der Vergleich V5 mit den beteiligten Daten B und D. Demgemäß werden im Schritt 88 die fehlerfreien Daten B oder D in die anderen Speicherbereiche a und c geladen. Im Schritt 90 wird aus den neuen Daten An und Cn in den Speicherbereichen a, c jeweils die Prüfsumme PSAn bzw. PSCn gebildet, die bei erneuter Ausführung des Verfahrens nach diesem Ausführungsbeispiel als erste Prüfsummen PSA, PSC verwendet werden. Über den Schritt 92 mit statistischer Auswertung der Fehler wird im Schritt 94 das Programm verlassen.

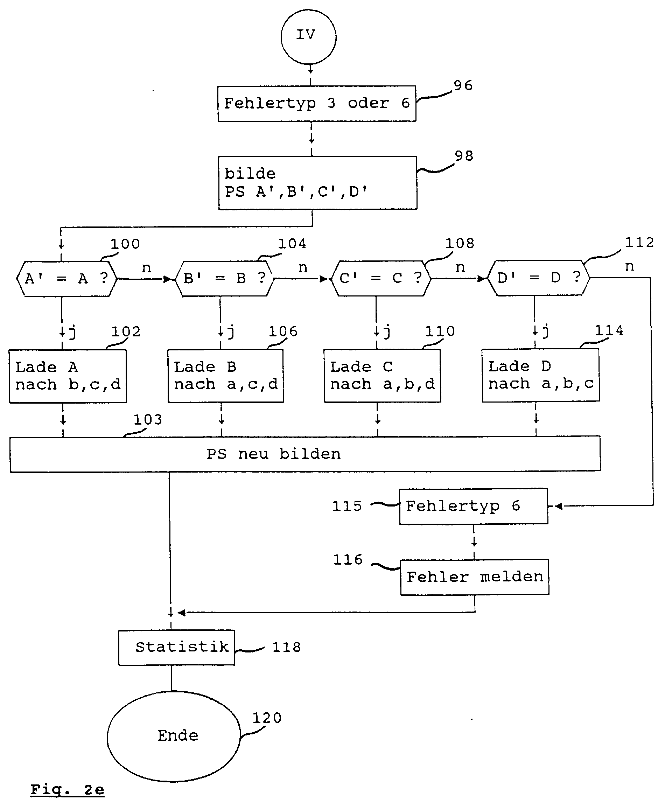

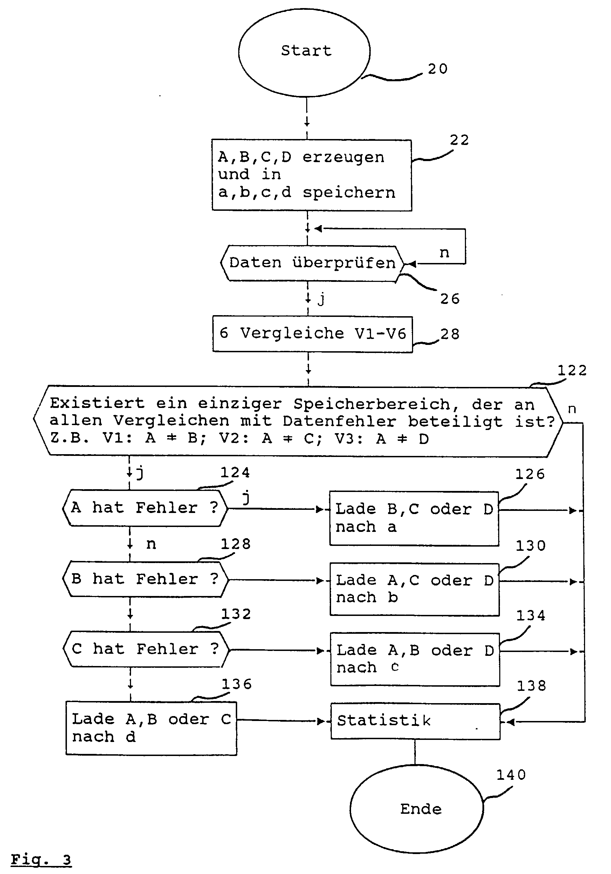

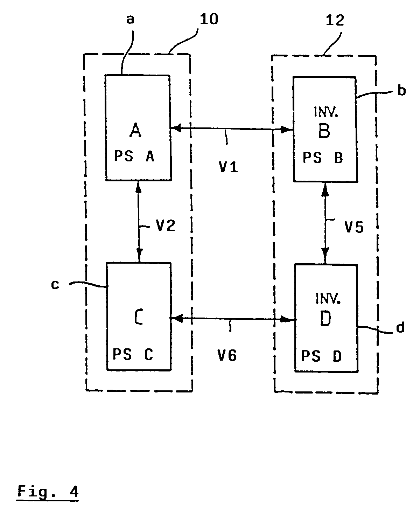

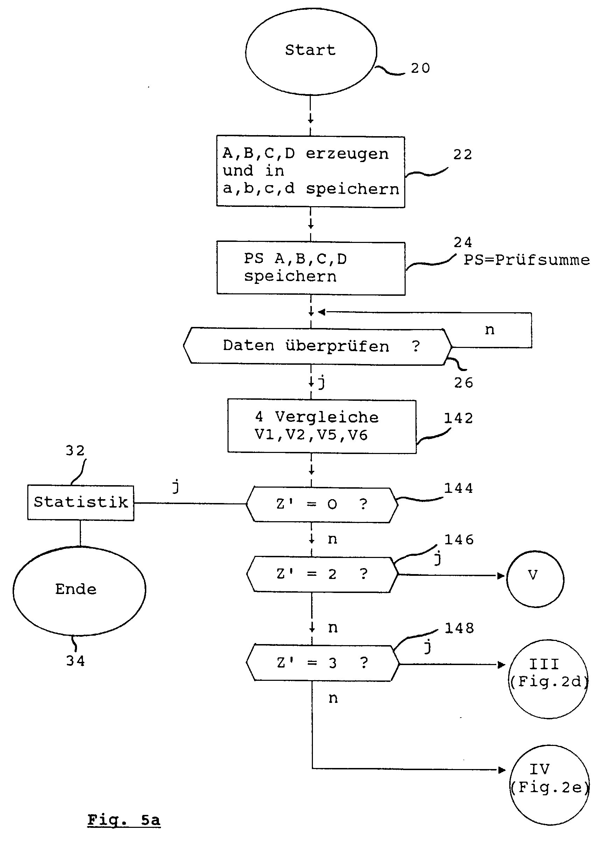

Der in Figur 2e dargestellte Programmabschnitt IV wird bei einem Fehlerzähler Z = 6 abgearbeitet. Dieser Fehlerzahl Z ist der Fehlertyp 3 oder 6 zugeordnet (vgl. Tabelle 3 und 6), was im Schritt 96 angegeben ist. Im darauffolgenden Schritt 98 wird aus den aktuellen Daten A bis D jeweils die zweite Prüfsumme PSA' bis PSD' gebildet. In den nachfolgenden Prüfschritten 100, 104, 108, 112 wird festgestellt, für welche Daten A bis D jeweils die erste Prüfsumme PSA bis PSD mit der zweiten Prüfsumme PSA' bis PSD' übereinstimmt. Bei Übereinstimmung wird zum nachfolgenden Schritt verzweigt, d.h. zu den Schritten 102, 106, 110 oder 114, und die fehlerfreien Daten werden jeweils in die anderen Speicherbereiche geladen, wie in vorgenannten den Verfahrensschritten 102, 106, 110 und 114 angegeben ist. Danach wird im Schritt 103 aus den neu abgespeicherten Daten die erste Prüfsumme gebildet und danach über den Schritt 118, in welchem die Fehler statistisch ausgewählt werden, im Schritt 120 das Programm verlassen.

Wenn im Schritt 112 festgestellt wird, daß keine der ersten Prüfsummen PSA bis PSD mit den entsprechenden zweiten Prüfsummen PSA' bis PSD' übereinstimmt, so liegt der Fehlertyp 6 vor (Schritt 115), d.h. sämtliche Daten A bis D haben unterschiedliche Fehler. Eine Berichtigung der Daten A bis D ist nicht möglich. Daher wird im Verfahrensschritt 116 ein Fehlersignal erzeugt, das anzeigt, daß die sicherheitsrelevanten Daten A bis D in der Frankiermaschine fehlerhaft sind.

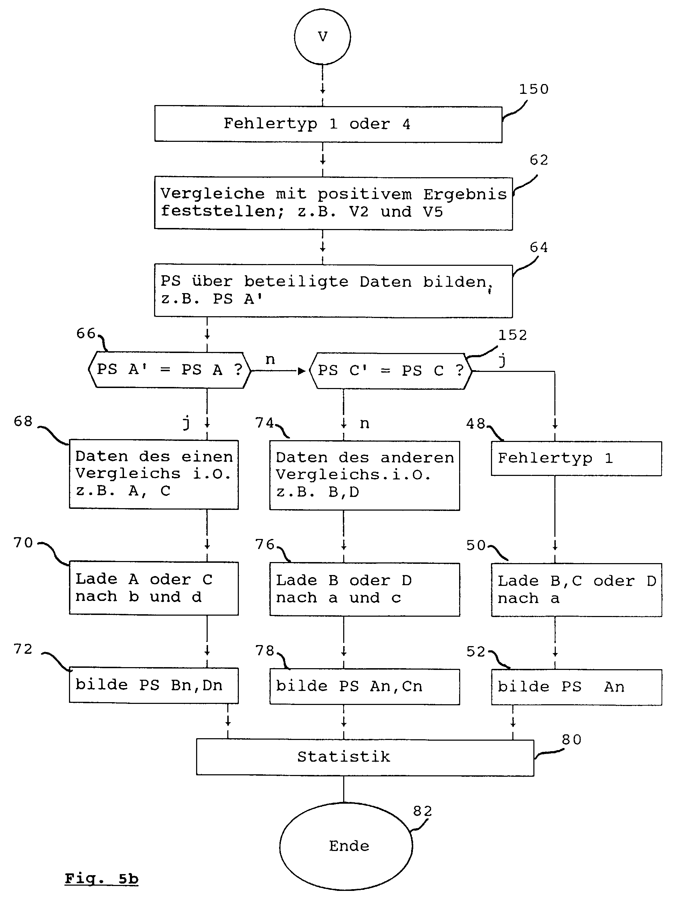

Das in Verbindung mit den Figuren 2a bis 2e beschriebene Ausführungsbeispiel behandelt die teilweise komplexen Fehlertypen 1 bis 6. In der Praxis kommt der Fehlertyp 1 am häufigsten vor, d.h. nur ein Speicherbereich hat einen Datenfehler; die Daten in den anderen Speicherbereichen sind jeweils einwandfrei. Für diesen in der Praxis bedeutsamen Fall wird im folgenden unter Bezugnahme auf das in der Figur 3 dargestellte Flußdiagramm ein vereinfachtes Ausführungsbeispiel der Erfindung beschrieben, bei dem keine Fehlerzahl Z ermittelt und ein Prüfsummenvergleich nicht durchgeführt wird. Demzufolge kann ein entsprechendes Programm sehr einfach aufgebaut sein und noch schneller abgearbeitet werden.

Die in der Figur 3 dargestellten Verfahrensschritte 20 bis 28 stimmen in ihrer Abfolge mit den beim Ausführungsbeispiel nach Figur 2a erläuterten überein, mit der Ausnahme, daß die dort beschriebene Ermittlung der Prüfsumme über die Daten A, B, C, D und deren Speicherung wegfällt (Verfahrensschritt 24 in Figur 2a). Nach dem Durchführen der sechs Vergleiche V1 bis V6 wird im Schritt 122 geprüft, ob ein Speicherbereich A, B, C, D existiert, der an allen Vergleichen mit Datenfehler beteiligt war. Wenn dies nicht zutrifft, so wird zum Schritt 138 verzweigt, in welchem dieser Betriebszustand statistisch ausgewertet und anschließend das Programm im Schritt 140 verlassen wird.

Wenn ein solcher Speicherbereich existiert, beispielsweise, wenn in Übereinstimmung mit der Tabelle 1 die Daten A fehlerhaft sind, so wird zum nächsten Schritt 124 verzweigt. In diesem wird festgestellt, daß die Daten A betroffen sind und im nachfolgenden Schritt 126 werden ordnungsgemäße Daten B, C oder D in den Speicherbereich a geladen. In analoger Weise wird verfahren, wenn Daten B (Verfahrensschritte 128 und 130), Daten C (Verfahrensschritte 132 und 134) oder Daten D (Verfahrensschritt 136) betroffen sind und durch ordnungsgemäße Daten jeweils ersetzt werden. Nach dem Ersetzen der Daten (Verfahrensschritte 126, 130, 134, 136) wird der festgestellte Fehler im Verfahrensschritt 138 statistisch ausgewertet und das Programm im Verfahrensschritt 140 verlassen.

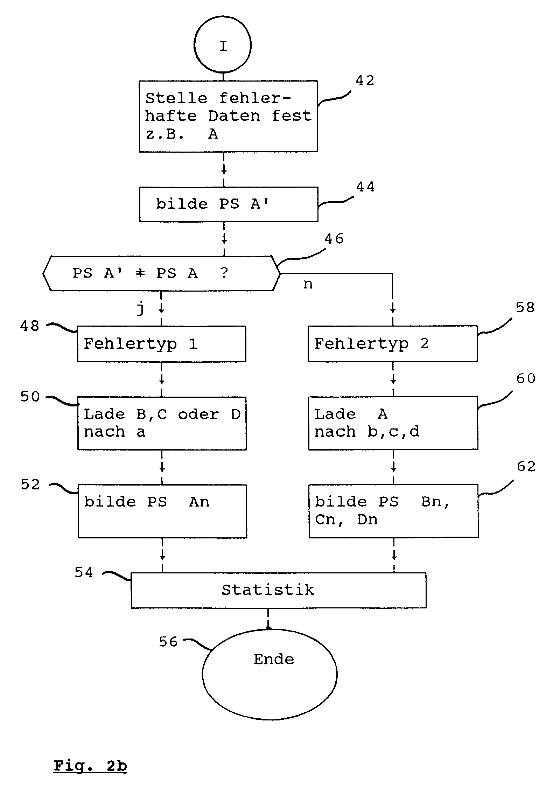

In Figur 4 ist ein weiteres Ausführungsbeispiel skizziert, das im wesentlichen mit dem zuvor beschriebenen Ausführungsbeispiel nach den Figuren 1 und 2 übereinstimmt. Im Unterschied zum vorherigen Ausführungsbeispiel werden aber nur vier Vergleiche V1, V2, V5, V6 zwischen den Daten A, B, C und D durchgeführt, d.h. die in Figur 1 skizzierten Vergleiche V3 und V4 wurden weggelassen. Entsprechend ändert sich bei den verschiedenen Fehlertypen 1 bis 6 gemäß den Tabellen 1 bis 6 jeweils die Fehlerzahl (es gilt nunmehr die Fehlerzahl Z') und die davon abhängigen Verfahrensschritte, wobei das Grundprinzip der Erfassung des Fehlertyps und die Berichtigung der Datenfehler beibehalten wird. Bei dem in Figur 4 gezeigten Ausführungsbeispiel kann die Überprüfung der Richtigkeit der gespeicherten Daten wegen der verringerten Zahl an Vergleichen sehr schnell durchgeführt werden. Dieses Ausführungsbeispiel wird daher für zeitkritische Anwendungen eingesetzt.

In den Figuren 5a und 5b sind in einem Flußdiagramm die Verfahrensschritte zum Erfassen des Fehlertyps und die entsprechende Reaktion darauf dargestellt. Verschiedene Abfolgen von Verfahrensschritten stimmen mit denen in den Figuren 2a bis 2e überein und werden mit ihren Bezeichnungen auch in den Figuren 5a und 5b verwendet. Auf eine detaillierte Beschreibung derartiger Verfahrensschritte kann daher bei der Erläuterung des folgenden Ausführungsbeispiels verzichtet werden.

Gemäß Figur 5a werden bei diesem Ausführungsbeispiel zunächst die bekannten Verfahrensschritte 20 bis 26 ausgeführt (vgl. Figur 2a). Im nachfolgenden Verfahrensschritt 142 werden die in Figur 4 eingezeichneten vier Vergleiche V1 , V2, V5, V6 durchgeführt und der Wert des Fehlerzählers Z' ermittelt. Die sich beim vorliegenden Ausführungsbeispiel ergebenden Fehlerzahlen Z' für die verschiedenen in den Tabellen 1 bis 6 dargestellten Fehlertypen sind dort in Klammern angegeben. Sie ergeben sich aus den Vergleichen V1, V2, V5, V6 mit jeweils fehlerhaften Daten, wobei die Vergleiche V3 und V4 nicht berücksichtigt werden.

Wird im Schritt 144 festgestellt, daß der Fehlerzähler Z' den Wert 0 hat, so wird über den Verfahrensschritt 32 das Programm im Schritt 34 verlassen. Hat der Fehlerzähler den Wert Z' = 2, so wird zum Programmabschnitt V verzweigt, der weiter unten in Verbindung mit Figur 5b erläutert wird.

Bei einem Fehlerzähler Z' = 3 (Verfahrensschritt 148) wird zu Verfahrensschritten verzweigt, die im Programmabschnitt III in Figur 2d angegeben sind. Es liegt der Fehlertyp 5 vor, wie er in der Tabelle 5 definiert ist. Nach Ablauf der bereits beschriebenen Verfahrensschritte 84 bis 94 wird das Programm verlassen.

Bei einer maximalen Fehlerzahl Z' = 4 wird über Verfahrensschritt 148 zum Programmabschnitt IV verzweigt, dessen Verfahrensschritte in Figur 2e dargestellt sind und den Fehlertyp 3 oder 6 behandeln (vgl. Tabelle 3 bzw. 6).

Im folgenden werden die in Figur 5b angegebenen Verfahrensschritte bei einem Fehlerzähler Z' = 2 beschrieben. Bei dieser Fehlerzahl Z' kann der Fehlertyp 1 oder der Fehlertyp 4 vorliegen (Verfahrensschritt 150). Diese Fehlertypen sind in den Tabellen 1 und 4 definiert. Es werden zunächst die auch beim Programmabschnitt II (Figur 2c) verwendeten Verfahrensschritte 62, 64 und 66 ausgeführt. In den Verfahrensschritten 66 und 152 wird entschieden, ob der Fehlertyp 1 oder der Fehlertyp 4 vorliegt. Handelt es sich um den Fehlertyp 4, d.h. die Daten zweier Speicherbereiche sind fehlerhaft, wobei jeweils derselbe Fehler vorliegt, so werden die aus dem Programmabschnitt II (Figur 2c) bekannten Verfahrensschritte 68 bis 72 oder die Verfahrensschritte 74 bis 78 ausgeführt und die Datenfehler korrigiert.

Wenn im Schritt 152 festgestellt wird, daß die Prüfsummen C' und C bei dem gewählten Beispiel übereinstimmen, so handelt es sich um den Fehlertyp 1, d.h. die Daten eines einzigen Speicherbereichs sind fehlerhaft. Zur Behebung des Fehlers werden die aus dem Programmabschnitt I (Fig. 2b) bekannten Verfahrensschritte 48 bis 52 ausgeführt. Zum Abschluß des Verfahrensablaufs wird eine statistische Auswertung im Schritt 80 vorgenommen und über Verfahrensschritt 82 das Programm verlassen.

## Patentansprüche

1. Verfahren zum Speichern sicherheitsrelevanter Daten in einer Frankiermaschine, bei dem gleiche Daten (A, B, C, D) in mehreren Speicherbereichen (a, b, c, d) abgespeichert werden, die Daten (A, B, C, D) aus den Speicherbereichen (a, b, c, d) wieder ausgelesen und Daten (z.B. A) des einen Speicherbereichs (a) mit Daten (z.B. B, C, D) eines anderen Speicherbereichs (z.B. b, c, d) verglichen werden, und bei dem Speicherbereiche mit fehlerhaften Daten festgestellt werden, **dadurch gekennzeichnet**, daß gleiche Daten (A, B, C, D) in mindestens vier Speicherbereichen (a, b, c, d) abgespeichert werden, daß die Daten (A, B, C, D) eines jeden Speicherbereichs (a, b, c, d) mit den Daten (A, B, C, D) weiterer Speicherbereiche (a, b, c, d) verglichen werden, und daß abhängig von diesem Vergleich (V1 bis V6) der oder die Speicherbereiche (a, b, c, d) mit fehlerhaften Daten (A, B, C, D) festgestellt und gegebenenfalls mit Daten (A, B, C, D) aus einem Speicherbereich (a, b, c, d) mit nicht fehlerhaften Daten wieder geladen werden.

2. Verfahren nach Anspruch 1, **dadurch gekennzeichnet**, daß in mindestens zwei Speicherbereichen (b, d) die Daten (B, D) invertiert abgespeichert werden und daß zum Vergleich mit nicht invertierten Daten (A, C) die invertierten Daten (B, D) negiert werden.

3. Verfahren nach Anspruch 1 oder 2, **dadurch gekennzeichnet**, daß der Vergleich (V1 bis V6) der Daten (A, B, C, D) durch eine Exklusiv-Oder-Verknüpfung erfolgt.

4. Verfahren nach einem der vorhergehenden Ansprüche, **dadurch gekennzeichnet**, daß der Vergleich (V1 bis V6) byteweise bitorientiert durchgeführt wird.

5. Verfahren nach einem der vorhergehenden Ansprüche, **dadurch gekennzeichnet**, daß eine Fehlerzahl (Z) ermittelt wird, die angibt, wie oft fehlende Übereinstimmung der Daten (A, B, C, D) der Speicherbereiche (a, b, c, d) vorliegt, und daß diese Fehler abhängig von der Fehlerzahl (Z) behoben werden.

6. Verfahren nach Anspruch 5, **dadurch gekennzeichnet**, daß vor oder beim Abspeichern der Daten (A, B, C, D) in den Speicherbereichen (a, b, c, d) aus den Daten (A, B, C, D) eines jeden Speicherbereiches (a, b, c, d) eine erste Prüfsumme (PSA bis PSD) gebildet und gespeichert wird, und daß bei Auslesen der Daten (A, B, C, D) oder danach aus den Daten (A, B, C, D) der Speicherbereiche (a, b, c, d) jeweils eine zweite Prüfsumme (PSA' bis PSD') ermittelt wird, die mit der ersten Prüfsumme (PSA bis PSD) verglichen wird, und daß Fehler abhängig vom Vergleich der Prüfsummen (PSA bis PSD; PSA' bis PSD') behoben werden.

7. Verfahren nach einem der vorhergehenden Ansprüche, dadurch **gekennzeichnet**, daß bei vier Speicherbereichen (a, b, c, d) vier Vergleiche (V1, V2, V5, V6) der Daten (A, B, C, D) und gegebenfalls der Prüfsummen (PSA bis PSD; PSA' bis PSD') durchgeführt werden.

8. Verfahren nach einem der Ansprüche 1 bis 6, dadurch **gekennzeichnet**, daß bei vier Speicherbereichen (a, b, c, d) sechs Vergleiche (V1 bis V6) der Daten (A, B, C, D) und gegebenenfalls der Prüfsummen (PSA bis PSD; PSA' bis PSD') durchgeführt werden.

9. Verfahren nach Anspruch 8, dadurch **gekennzeichnet**, daß bei einer Fehlerzahl (Z) 3 derjenige Speicherbereich (A) ermittelt wird, der bei drei Vergleichen (V1, V2, V3) Datenfehler gezeigt hat, daß die erste und zweite Prüfsumme (PSA, PSA') dieses Speicherbereichs (a) miteinander verglichen werden, und daß dieser Speicherbereich (a) mit Daten (B) bzw. invertierten Daten aus einem der anderen Speicherbereiche (b) geladen wird, wenn beim Prüfsummenvergleich (46) keine Übereinstimmung festgestellt worden ist.

10. Verfahren nach Anspruch 8, dadurch **gekennzeichnet**, daß bei der Fehlerzahl (Z) 3 derjenige Speicherbereich (a) ermittelt wird, der bei drei Vergleichen (V1, V2, V3) Datenfehler gezeigt hat, daß die erste und zweite Prüfsumme (PSA, PSA') dieses Speicherbereichs (a) miteinander verglichen werden, und daß die Daten (A) dieses Speicherbereichs (a) in die anderen Speicherbereiche (b, c, d) gespeichert werden, wenn beim Prüfungssummenvergleich (46) Übereinstimmung festgestellt worden ist.

11. Verfahren nach Anspruch 8, dadurch **gekennzeichnet**, daß bei der Fehlerzahl (Z) 4 diejenigen Speicherbereiche (a, c; b, d) ermittelt werden, deren Vergleiche (V2, V5) der Daten (A, B, C, D) Übereinstimmung gezeigt haben, daß unter diesen Speicherbereichen diejenigen Speicherbereiche (a, c; b, d) ohne Datenfehler durch Prüfsummenvergleich (66) ermittelt werden, und daß die Daten (A oder C; B oder D) einer dieser Speicherbereiche (a, c; b, d) in die fehlerbehafteten Speicherbereiche (b, d; a, c) abgespeichert werden.

12. Verfahren nach Anspruch 8, dadurch **gekennzeichnet**, daß bei der Fehlerzahl (Z) 5 diejenigen Speicherbereiche (b, d) mit Übereinstimmung der Daten (B, D) ermittelt werden, und daß die Daten (B oder D) eines dieser Speicherbereiche (b, d) in die anderen Speicherbereiche (a, c) geladen werden.

13. Verfahren nach Anspruch 8, dadurch **gekennzeichnet**, daß bei der Fehlerzahl (Z) 6 für jeden Speicherbereich (a, b, c, d) ein Prüfsummenvergleich (100, 104, 108, 112) durchgeführt wird, und daß die Daten des Speicherbereichs mit positivem Vergleichsergebnis (102, 106, 110, 114) in die anderen Speicherbereiche geladen werden.

14. Verfahren nach Anspruch 13, dadurch **gekennzeichnet**, daß bei negativem Ergebnis aller Prüfsummenvergleiche ein Fehlersignal (116) erzeugt wird, das angibt, daß der Fehler nicht behoben werden kann.

15. Verfahren nach einem der vorhergehenden Ansprüche, dadurch **gekennzeichnet**, daß aus den in Speicherbereiche (a, b, c, d) mit zuvor fehlerhaften Daten (A, B, C, D) zu speichernden Daten (An, Bn, Cn, Dn) die erste Prüfsumme (PSAn bis PSDn) erneut gebildet und gespeichert wird.

16. Verfahren nach einem der vorhergehenden Ansprüche, dadurch **gekennzeichnet**, daß die über einen vorgegebenen Zeitraum je Speicherbereich (a, b, c, d) auftretenden Fehler ermittelt und angezeigt werden.

17. Verfahren nach einem der vorhergehenden Ansprüche, dadurch **gekennzeichnet**, daß es selbsttätig in vorgegebenen Zeitabständen oder abhängig von einem äußeren Ereignis (26) durchgeführt wird.

18. Verfahren nach einem der vorhergehenden Ansprüche, dadurch **gekennzeichnet**, daß die Daten (A, B, C, D) in physikalisch voneinander getrennten elektronischen Speichern (10, 12) gespeichert werden.

## Claims

1. Method for storing data that is relevant to security in a franking machine, by which method identical data (A, B, C, D) is stored in a plurality of storage areas (a, b, c, d), the data (A, B, C, D) is read back out from the storage areas (a, b, c, d) and data (for example A) of the one storage area (a) is compared with data (for example B, C, D) of another storage area (for example b, c, d), and by which method storage areas having erroneous data are detected, characterised in that identical data (A, B, C, D) is stored in at least four storage areas (a, b, c, d), in that the data (A, B, C, D) of each storage area (a, b, c, d) is compared with the data (A, B, C, D) of further storage areas (a, b, c, d), and in that as a function of this comparison (V1 to V6) the storage area or storage areas (a, b, c, d) that has/have erroneous data (A, B, C, D) is/are detected and, if applicable, reloaded with data (A, B, C, D) from a storage area (a, b, c, d) having non-erroneous data.

2. Method according to claim 1, characterised in that the data (B, D) is stored in an inverted manner in at least two storage areas (b, d), and in that for the purposes of comparison with non-inverted data (A, C) the inverted data (B, D) is negated.

3. Method according to claim 1 or 2, characterised in that the comparison (V1 to V6) of the data (A, B, C, D) is effected by means of an exclusive-OR operation.

4. Method according to one of the preceding claims, characterised in that the comparison (V1 to V6) is carried out byte by byte in a bit-oriented manner.

5. Method according to one of the preceding claims, characterised in that an error number (Z) is determined that indicates how often there is a lack of correspondence of the data (A, B, C, D) of the storage areas (a, b, c, d), and in that these errors are eliminated as a function of the error number (Z).

6. Method according to claim 5, characterised in that before or when storing the data (A, B, C, D) in the storage areas (a, b, c, d) a first check sum (PSA to PSD) is formed from the data (A, B, C, D) of each storage area (a, b, c, d) and is stored, and in that, when reading out the data (A, B, C, D) or afterwards, a respective second check sum (PSA' to PSD') is determined from the data (A, B, C, D) of the storage areas (a, b, c, d) and is compared with the first check sum (PSA to PSD), and in that errors are eliminated as a function of the comparison of the check sums (PSA to PSD; PSA' to PSD').

7. Method according to one of the preceding claims, characterised in that in the case of four storage areas (a, b, c, d) four comparisons (V1, V2, V5, V6) of the data (A, B, C, D) and, if applicable, of the check sums (PSA to PSD; PSA' to PSD') are carried out.

8. Method according to one of the claims 1 to 6, characterised in that in the case of four storage areas (a, b, c, d) six comparisons (V1 to V6) of the data (A, B, C, D) and, if applicable, of the check sums (PSA to PSD; PSA' to PSD') are carried out.

9. Method according to claim 8, characterised in that in the case of an error number (Z) of 3 that storage area (A) which has shown data errors in three comparisons (V1, V2, V3) is determined, in that the first check sum (PSA) and the second check sum (PSA') of this storage area (a) are compared with each other, and in that this storage area (a) is loaded with data (B) or inverted data from one of the other storage areas (b) if no correspondence has been established in the check sum comparison (46).

10. Method according to claim 8, characterised in that in the case of the error number (Z) of 3 that storage area (a) which has shown data errors in three comparisons (V1, V2, V3) is determined, in that the first check sum (PSA) and the second check sum (PSA') of this storage area (a) are compared with each other, and in that the data (A) of this storage area (a) is stored in the other storage areas (b, c, d) if correspondence has been established in the check sum comparison (46).

11. Method according to claim 8, characterised in that in the case of the error number (Z) of 4 those storage areas (a, c; b, d), the comparisons (V2,V5) of the data (A, B, C, D) of which have shown correspondence, are determined, in that of these storage areas those storage areas (a, c; b, d) without data errors are determined by means of a check sum comparison (66), and in that the data (A or C; B or D) of one of these storage areas (a, c; b, d) is stored in the error-containing storage areas (b, d; a, c).

12. Method according to claim 8, characterised in that in the case of the error number (Z) of 5 those storage areas (b, d) which have correspondence of the data (B, D) are determined, and in that the data (B or D) of one of these storage areas (b, d) is loaded into the other storage areas (a, c).

13. Method according to claim 8, characterised in that in the case of the error number (Z) of 6 a check sum comparison (100, 104, 108, 112) is carried out for each storage area (a, b, c, d), and in that the data of the storage area that has a positive result of comparison (102, 106, 110, 114) is loaded into the other storage areas.

14. Method according to claim 13, characterised in that in the case of a negative result for all the check sum comparisons an error signal (116) is generated that indicates that the error cannot be eliminated.

15. Method according to one of the preceding claims, characterised in that the first check sum (PSAn to PSDn) is formed anew from the data (An, Bn, Cn, Dn) to be stored in storage areas (a, b, c, d) having previously erroneous data (A, B, C, D) and is stored.

16. Method according to one of the preceding claims, characterised in that the errors which occur over a given period of time per storage area (a, b, c, d) are determined and indicated.

17. Method according to one of the preceding claims, characterised in that it (the method) is automatically carried out at given time intervals or as a function of an external event (26).

18. Method according to one of the preceding claims, characterised in that the data (A, B, C, D) is stored in electronic stores (10, 12) which are physically separate from each other.

## Revendications

1. Procédé pour mémoriser des données de sécurité dans une machine à affranchir, selon lequel on mémorise des données (A, B, C, D) identiques dans plusieurs zones de mémoire (a, b, c, d), on extrait de nouveau les données (A, B, C, D) des zones de mémoire (a, b, c, d) et on compare des données (par exemple A) de l'une des zones de mémoire (a) avec des données (par exemple B, C, D) de l'autre zone de mémoire (par exemple b, c, d) et selon lequel on détecte les zones de mémoire qui contiennent des données erronées, caractérisé par le fait que l'on mémorise des données (A, B, C, D) identiques dans au moins quatre zones de mémoire (a, b, c, d), que l'on compare les données (A, B, C, D) de chacune des zones de mémoire (a, b, c, d) aux données (A, B, C, D) des autres zones de mémoire (a, b, c, d) et par le fait que, en fonction de cette comparaison (V1 à V6), on détecte la ou les zones de mémoire (a, b, c, d) contenant des données erronées (A, B, C, D) et le cas échéant on charge de nouveau lesdites zones de mémoire avec des données (A, B, C, D) en provenance d'une zone de mémoire (a, b, c, d) qui contient des données non erronées.

2. Procédé selon la revendication 1, caractérisé par le fait que dans au moins deux zones de mémoire (b, d), on mémorise les données (B, D) sous forme d'inverses et par le fait que pour la comparaison avec des données non inversées (A, C) on nie les données inversées (B, D).

3. Procédé selon la revendication 1 ou 2, caractérisé par le fait que l'on opère la comparaison (V1 à V6) des données (A, B, C, D) par une opération OU exclusif.

4. Procédé selon une des revendications précédentes, caractérisé par le fait que la comparaison (V1 à V6) est orientée bit et est réalisée octet par octet.

5. Procédé selon une des revendications précédentes, caractérisé par le fait que l'on détermine un nombre d'erreurs (Z) qui indique le nombre de fois où il n'y a pas concordance entre les données (A, B, C, D) des zones de mémoire (a, b, c, d) et par le fait que l'on élimine les erreurs en fonction du nombre d'erreurs (Z).

6. Procédé selon la revendication 5, caractérisé par le fait qu'avant de mémoriser les données (A, B, C, D) dans les zones de mémoire (a, b, c, d) ou lors de leur mémorisation, on forme à partir des données (A, B, C, D) de chacune des zones de mémoire (a, b, c, d) une première somme de contrôle (PSA à PSD) et on la mémorise et par le fait que, lors de l'extraction des données (A, B, C, D) ou après celle-ci, on calcule une deuxième somme de contrôle (PSA' à PSD') à partir des données (A, B, C, D) des zones de mémoire (a, b, c, d) et que l'on compare à la première somme de contrôle (PSA à PSD) et que l'on élimine les erreurs en fonction de la comparaison des sommes de contrôle (PSA à PSD; PSA' à PSD').

7. Procédé selon une des revendications précédentes, caractérisé par le fait que dans le cas de quatre zones de mémoire (a, b, c, d) on réalise quatre comparaisons (V1, V2, V5, V6) des données (A, B, C, D) et le cas échéant des sommes de contrôle (PSA à PSD; PSA' à PSD').

8. Procédé selon une des revendications 1 à 6, caractérisé par le fait que dans le cas de quatre zones de mémoire (a, b, c, d) on réalise six comparaisons (V1 à V6) des données (A, B, C, D) et le cas échéant des sommes de contrôle (PSA à PSD; PSA' à PSD').

9. Procédé selon la revendication 8, caractérisé par le fait que dans le cas d'un nombre d'erreurs (Z) égal à 3, on détermine la zone de mémoire (a) qui lors de trois comparaisons (V1, V2, V3) a produit des erreurs de données, par le fait que l'on compare entre elles les première et deuxième sommes de contrôle (PSA, PSA') de cette zone de mémoire (a) et par le fait que l'on charge cette zone de mémoire (a) avec des données (B) ou des données inversées provenant de l'une des autres zones de mémoire (b) lorsque la comparaison (46) des sommes de contrôle ne fait pas apparaître une concordance.

10. Procédé selon la revendication 8, caractérisé par le fait que dans le cas d'un nombre d'erreurs (Z) égal à 3, on détermine la zone de mémoire (a) qui lors de trois comparaisons (V1, V2, V3) a produit des erreurs de données, par le fait que l'on compare entre elles les première et deuxième sommes de contrôle (PSA, PSA') pour cette zone de mémoire (a) et par le fait que l'on mémorise les données (A) de cette zone de mémoire (a) dans les autres zones de mémoire (b, c, d) lorsqu'une concordance a été constatée lors de la comparaison (46) des sommes de contrôle.

11. Procédé selon la revendication 8, caractérisé par le fait que dans le cas d'un nombre d'erreurs (Z) égal à 4, on détermine les zones de mémoire (a, c; b, d) pour lesquelles les comparaisons (V2, V5) des données (A, B, C, D) ont fait apparaître une concordance, par le fait que parmi ces zones de données on détermine par comparaison (66) des sommes de contrôle les zones de mémoire (a, c; b, d) sans erreurs de données et par le fait que l'on mémorise les données (A ou C; B ou D) de l'une de ces zones de mémoire (a, c; b, d) dans les zones de mémoire (b, d; a, c) contenant des erreurs.

12. Procédé selon la revendication 8, caractérisé par le fait que dans le cas d'un nombre d'erreurs (Z) égal à 5, on détermine les zones de mémoire (b, d) où il y a concordance des données (B, D) et par le fait qu'on charge les données (B ou D) de l'une de ces zones de mémoire (b, d) dans les autres zones de mémoire (a, c).

13. Procédé selon la revendication 8, caractérisé par le fait que dans le cas d'un nombre d'erreurs (Z) égal à 6, on procède pour chaque zone de mémoire (a, b, c, d) à une comparaison (100, 104, 108, 112) des sommes de contrôle et par le fait que l'on charge les données de la zone de mémoire produisant un résultat de comparaison positif (102, 106, 110, 114) dans les autres zones de mémoire.

14. Procédé selon la revendication 13, caractérisé par le fait que dans le cas d'un résultat négatif de toutes les comparaisons des sommes de contrôle, on génère un signal d'erreur (116) qui indique que l'erreur ne peut pas être corrigée.

15. Procédé selon une des revendications précédentes, caractérisé par le fait qu'à partir des données (An, Bn, Cn, Dn) à mémoriser dans les zones de mémoire (a, b, c, d) qui contenaient auparavant des données erronées (A, B, C, D), on forme de nouveau la première somme de contrôle (PS An à PSDn) et on la mémorise.

16. Procédé selon une des revendications précédentes, caractérisé par le fait qu'on détermine le nombre d'erreurs qui apparaissent dans chaque zone de mémoire (a, b, c, d) dans un intervalle de temps prédéterminé et on l'affiche.

17. Procédé selon une des revendications précédentes, caractérisé par le fait qu'il se déroule de manière automatique à intervalles prédéterminés ou en fonction d'un événement extérieur (26).

18. Procédé selon une des revendications précédentes, caractérisé par le fait que l'on mémorise les données (A, B, C, D) dans des mémoires électroniques (10, 12) physiquement séparées les unes des autres.
